Europäisches Patentamt

European Patent Office

Office européen des brevets

(11) Veröffentlichungsnummer: **0 511 527 A1**

# (12) EUROPÄISCHE PATENTANMELDUNG

(21) Anmeldenummer: **92106113.1**

(22) Anmeldetag: **09.04.92**

(51) Int. Cl.⁵: **E06B 5/18**, H05K 9/00

(30) Priorität: **30.04.91 DE 4114099**

(43) Veröffentlichungstag der Anmeldung:
**04.11.92 Patentblatt 92/45**

(84) Benannte Vertragsstaaten:
**AT BE CH DE DK ES FR GB GR IT LI NL PT SE**

(71) Anmelder: **MWB MESSWANDLER-BAU AG**
**Nürnberger Strasse 199**
**W-8600 Bamberg(DE)**

(72) Erfinder: **Schaller, Rudolf, Dipl.-Ing(FH).**
**Südring 17**
**W-8401 Alteglofsheim(DE)**
Erfinder: **Bienia, Richard**
**Sudetenweg 5**
**W-8401 Wenzenbach(DE)**
Erfinder: **Schüssler, Johann**
**Eichendorffstrasse 20**
**W-8543 Hipoltstein(DE)**

(74) Vertreter: **Hufnagel, Walter, Dipl.-Ing.,**
**Dipl.-Wirtsch.-Ing. et al**
**Dorner & Hufnagel Patentanwälte Bad**
**Brückenauer Str. 19**
**W-8500 Nürnberg 90(DE)**

(54) **Den Durchgang elektromagnetischer Felder verhindernde Tür.**

(57) Bei einer den Durchgang elektromagnetischer Felder verhindernden Tür, bestehend aus einer Zarge (2) und einem Türblatt (10, 12), das entlang seinen Rändern zungenförmige Kontakte (7, 8) aufweist, die mit an der Zarge (2) angebrachten korrespondierenden Kontakten (5, 6) zusammenwirken, wobei wenigstens die Hälfte aller Kontakte (5, 6, 7, 8) mit Kontaktfedern (9) versehen ist, wird die Aufgabe, neben der Schonung der Kontakte (5, 6, 7, 8) eine bessere Abschirmwirkung, insbesondere im kHz-Bereich, zu erreichen und außerdem die aufzuwendenden Kräfte für das Schließen und Öffnen der Tür herabzusetzen, dadurch gelöst, daß das Türblatt (10, 12) nur um eine einzige, bezüglich der Zarge (2) feststehende Gelenkachse (20) schwenkbar gelagert ist, wobei wenigstens ein Paar zusammenwirkender Kontakte (6, 8) schräg abgewinkelt ist und der Abstand dieser Kontakte (6, 8) zueinander in keiner der möglichen Stellungen der Tür kleiner ist als in der Schließstellung.

FIG.2

Die Erfindung betrifft eine den Durchgang elektromagnetischer Felder verhindernde Tür, bestehend aus einer Zarge und einem Türblatt, das entlang seinen Rändern zungenförmige Kontakte aufweist, die mit an der Zarge angebrachten korrespondierenden Kontakten zusammenwirken, wobei wenigstens die Hälfte aller Kontakte mit Kontaktfedern versehen ist.

Zum Sicherstellen der elektromagnetischen Verträglichkeit von elektrischen, elektronischen oder nachrichtentechnischen Geräten ist es wichtig, die Ausbreitung elektrischer und magnetischer Felder in bestimmten Raumbereichen zu verhindern. Es ist daher oftmals erforderlich, derartige Geräte durch Einbau in abschirmende Gehäuse, Kabinen oder Räume abstrahlungssicher zu machen.

Elektrische und elektrostatische Felder sind durch dünne Metallfolien leicht abzuschirmen, während magnetische und magnetostatische Felder durch völlig geschlossene Gehäuse oder Räume aus ferromagnetischen Materialien abgeschwächt werden können.

An den Kontaktstellen zwischen einer beispielsweise in die Wand eines gegen elektromagnetische Felder abgeschirmten Raumes eingebauten Türzarge und dem Türblatt ist die Abschirmwirkung geringer als bei den Abschirmelementen der Wände, des Bodens und der Decke dieses Raumes. Daher besteht ständig das Bestreben, die Abschirmwirkung dieser Kontaktstellen zu verbessern und an die jeweiligen Forderungen anzupassen.

Aus der EP-PS 0 095 743 ist bereits eine Tür der eingangs erwähnten Art bekannt, bei der zur besseren Kontaktgabe zwischen den Kontakten der Zarge und denen des Türblattes die Bewegung der Tür zum öffnen oder Schließen in zwei Phasen aufgeteilt ist, wobei die eine Phase aus einer Schwenkbewegung um durch ein Gelenk vorgegebene Achsen und die andere Phase aus einer etwa geradlinigen, rechtwinkelig zum Rahmen der Tür verlaufenden Bewegung besteht. Um diese zwei Bewegungsphasen zu verwirklichen, ist eine aufwendige mechanische Türsteuerung erforderlich, die außerdem nicht den gewünschten Erfolg hat, so daß die Kontakte durch seitliche Ausschläge bei der Schließ- oder Öffnungsbewegung stark belastet werden und dadurch schnell erlahmen. Eine gute Abschirmung gegen elektromagnetische Felder ist danach nicht mehr möglich.

Der Erfindung liegt daher die Aufgabe zugrunde, die eingangs erwähnte Tür so zu gestalten, daß neben der Schonung der Kontakte eine bessere Abschirmwirkung, insbesondere im kHz-Bereich erreicht wird. Außerdem sollen die aufzuwendenden Kräfte für das Schließen und Öffnen der Tür herabgesetzt werden.

Diese Aufgabe wird nach dem Kennzeichen des Anspruchs 1 dadurch gelöst, daß das Türblatt nur um eine einzige, bezüglich der Zarge feststehende Gelenkachse schwenkbar gelagert ist, wobei wenigstens ein Paar zusammenwirkender Kontakte schräg abgewinkelt ist und der Abstand dieser Kontakte zueinander in keiner der möglichen Stellungen der Tür kleiner ist als in der Schließstellung.

Nach einer vorteilhaften Weiterbildung der Erfindung bildet die Richtung wenigstens eines Paares zusammenwirkender Kontakte mit der Verbindungslinie zwischen ihrem bei geschlossener Tür sich ergebenden Berührungspunkt und der Gelenkachse einen rechten Winkel. Dadurch wird erreicht, daß der Abstand dieser Kontakte zueinander während des Schließvorganges sich nur sehr wenig ändert.

Nach einer anderen Weiterbildung der Erfindung ist wenigstens ein Paar zusammenwirkender Kontakte rechtwinkelig zum Türblatt ausgerichtet, wobei der an der Zarge angebrachte Kontakt einen kleineren Abstand von der Gelenkachse hat als der an dem Türblatt angebrachte Kontakt. Dadurch wird erreicht, daß der Abstand dieser Kontakte zueinander in keiner der möglichen Stellungen der Tür kleiner ist als in der Schließstellung.

Weitere Ausführungsformen sind dadurch gekennzeichnet, daß wenigstens ein an der Zarge angebrachter doppelter Kontakt einen etwa U-förmigen Querschnitt mit schräg nach innen abgewinkelten Schenkeln aufweist und mit ferromagnetischem Material oder mit Absorbermaterial gefüllt ist, das aus Schaumstoff besteht, der mit leitendem, verlustbehafteten Material, insbesondere auf der Basis von Kohlenstoff, getränkt ist.

Nach einer anderen Ausgestaltung der Erfindung weist wenigstens ein an dem Türblatt angebrachter doppelter Kontakt einen etwa U-förmigen Querschnitt mit einem schräg nach außen abgewinkelten Schenkel auf, während wenigstens ein an der Zarge angebrachter Kontakt mit einem L-förmigen Querschnitt mit einem rechtwinkelig abgewinkelten Schenkel ausgestattet ist. Ein weiterer an dem Türblatt angebrachter Kontakt weist dagegen einen etwa L-förmigen Querschnitt mit einem schräg nach außen abgewinkelten Schenkel auf.

Nach einer weiteren Ausgestaltung der Erfindung sind die Kontakte unter Zwischenlage eines Dichtungsgeflechtes, zum Beispiel eines doppelten Gestrickbandes, oder mittels Schutzgas-Schweißung an der Zarge bzw. an dem Türblatt befestigt.

Die Kontaktfedern sind auf die Kontakte aufsteckbar und weisen einen in eine Nut einrastenden Schnappverschluß auf. Dabei ist von jedem Paar korrespondierender Kontakte wenigstens einer mit einer Kontaktfeder versehen.

Zur Abdichtung der kompletten Tür sind die Kontakte in Form von Kontaktreihen, teilweise mit aufgesteckten Kontaktfederreihen, an den Rändern des Türblattes bzw. an der Zarge umlaufend angeordnet.

Die mit der Erfindung erzielten Vorteile bestehen insbesondere darin, daß die Tür trotz geringer Schließkräfte eine gute Kontaktgabe zwischen der Zarge und dem Türblatt aufweist und eine gute Sperre für die elektromagnetischen Felder darstellt. Durch die besondere Anordnung der die Kontaktfedern tragenden Kontakte und U-förmigen Profile ergibt sich eine Erhöhung der Hohlrauminduktivität zwischen den Federreihen, wodurch sich eine erhebliche Verbesserung der Abschirmwirkung im kHz-Bereich ergibt. Da diese Tür nur eine einfache Schwenkbewegung um eine feste Achse ausführt, benötigt sie keine komplizierten Gestänge und Mechanismen zum Bedienen der Tür, wodurch sie billiger und dennoch störungssicher hergestellt werden kann.

Ein Ausführungsbeispiel der Erfindung ist in der Zeichnung dargestellt und wird im folgenden näher beschrieben. Es zeigen

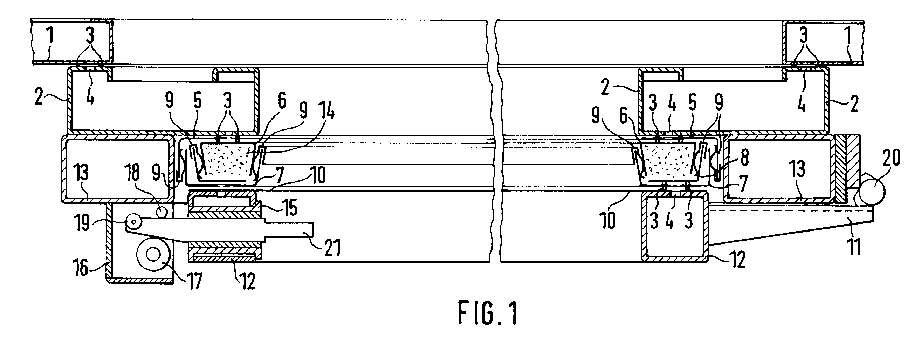

Figur 1    einen Schnitt durch eine in eine Wand eingebaute Tür,

Figur 2    einen Schnitt durch die Tür an der Gelenkseite und

Figur 3    einen Schnitt durch die Tür an der Verschlußseite.

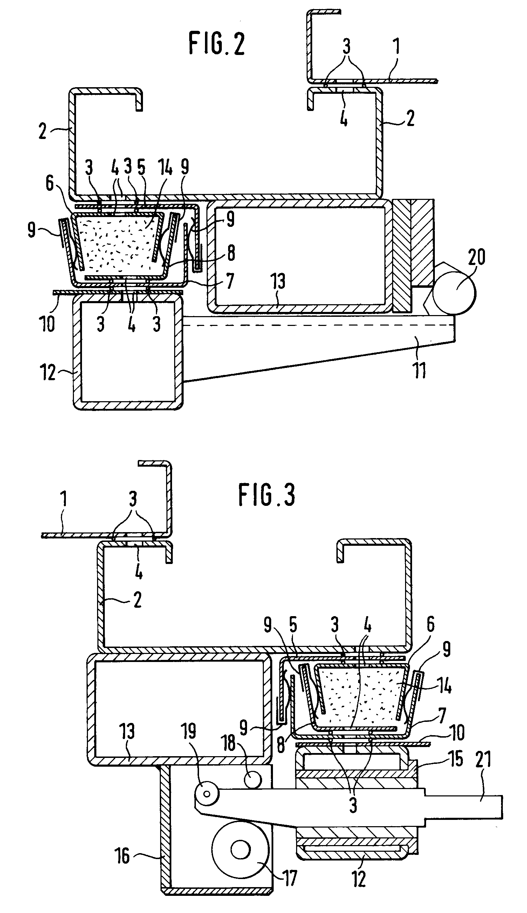

An einer Wand 1 ist eine Zarge 2 unter Zwischenlage eines Dichtungsgeflechtes 3, zum Beispiel eines doppelten Gestrickbandes, mit durch Bohrungen 4 gehenden (nicht dargestellten) Schrauben befestigt. Ein Versteifungsprofil 13, das auf der Zarge 2 aufgesetzt ist, dient gleichzeitig als Träger für eine Gelenkachse 20 (Fig. 2), an der ein mit einem Türblatt 10, 12 verbundenes Scharnier 11 schwenkbar gelagert ist. Das Türblatt besteht aus einem Rahmenprofil 12, an dem das Scharnier 11 und ein Abschirmblech 10 befestigt sind.

Das Türblatt 10, 12 weist entlang seinen Rändern zungenförmige Kontakte 7, 8 auf, die mit an der Zarge 2 angebrachten korrespondierenden Kontakten 5, 6 zusammenwirken, wobei ein Paar zusammenwirkender Kontakte 6, 8 derart schräg abgewinkelt ist, daß der Abstand dieser Kontakte 6, 8 zueinander in keiner der möglichen Stellungen der Tür kleiner ist als in der Schließstellung. Dadurch erreicht der Kontaktdruck immer nur in der Schließstellung seinen größten Wert, so daß während des Schließvorganges kein größerer Druck die Kontakte belastet und diese nicht beschädigt werden können.

Die günstigste Schräglage dieses Paares zusammenwirkender Kontakte 6, 8 ergibt sich dann, wenn ihre Richtung mit der Verbindungslinie zwischen ihrem bei geschlossener Tür sich ergebenden Berührungspunkt und der Gelenkachse 20 einen rechten Winkel bildet (Fig. 2).

Ein weiteres Paar zusammenwirkender Kontakte 5, 7 ist rechtwinkelig zum Türblatt 10, 12 ausgerichtet, wobei der an der Zarge 2 angebrachte Kontakt 5 einen kleineren Abstand von der Gelenkachse 20 hat als der an dem Türblatt angebrachte Kontakt 7 (Fig. 2). Dadurch wird die oben erwähnte Forderung erfüllt, daß der Kontaktdruck immer nur in der Schließstellung seinen größten Wert erreicht.

Der an der Zarge 2 angebrachte Kontakt 6 ist ein Doppelkontakt mit einem etwa U-förmigen Querschnitt und schräg nach innen abgewinkelten Schenkeln, wobei dessen Innenraum entweder mit ferromagnetischem Material 14 oder mit Absorbermaterial gefüllt ist, das aus Schaumstoff besteht, der mit leitendem, verlustbehafteten Material, insbesondere auf der Basis von Kohlenstoff, getränkt ist.

An dem Türblatt 10, 12 ist ebenfalls ein doppelter Kontakt 7 mit einem etwa U-förmigen Querschnitt angebracht, aber mit einem schräg nach außen abgewinkelten Schenkel, während der andere Schenkel rechtwinkelig zum Türblatt 10, 12 ausgerichtet ist, dessen mit ihm zusammenwirkender an der Zarge 2 angebrachte Kontakt 5 ebenfalls einen L-förmigen Querschnitt mit einem rechtwinkelig abgewinkelten Schenkel aufweist.

Ein weiterer an dem Türblatt 10, 12 angebrachter Kontakt 8 weist einen etwa L-förmigen Querschnitt mit einem schräg nach außen abgewinkelten Schenkel auf, der mit dem einen Schenkel des Doppelkontaktes 6 zusammenwirkt.

Alle Kontakte 5, 6, 7, 8 sind unter Zwischenlage eines Dichtungsgeflechtes 3, zum Beispiel eines doppelten Gestrickbandes, an der Zarge 2 bzw. an dem Türblatt 10, 12 befestigt, wobei Bohrungen 4 entsprechende Schrauben oder Nieten aufnehmen können.

Von jedem Paar korrespondierender Kontakte 6/7, 6/8, 5/7 ist jeweils einer mit einer Kontaktfeder 9 versehen. Diese Kontaktfedern 9 können auf die Kontakte 5, 6, 7, 8 aufgesteckt werden und rasten dort in eine Nut eines Schnappverschlusses ein.

Die Kontakte 5, 6, 7, 8 sind in Form von Kontaktreihen an den Rändern des Türblattes 10, 12 bzw. an der Zarge 2 umlaufend angebracht.

Auf der Verschlußseite (Fig. 3) ist in das Türblatt-Rahmenprofil 12 eine Lagerbuchse 15 eingebaut, in der ein Schließkeil 21 in waagerechter Richtung verschiebbar angeordnet ist. Beim Schließen der Tür wird das Türblatt 10, 12 von Hand bis an die Kontakte 5, 6, 7, 8 herangeführt. In dieser Stellung wird über einen entsprechenden (nicht dargestellten) Mechanismus der Schließkeil 21 in Richtung des Schließkastens 16 bewegt. Dabei läuft eine Abschrägung des Schließkeiles 21 auf eine Schließrolle 17 auf, wodurch sich das Türblatt 10, 12 zur Zarge 2 hinbewegt, bis die Schließstellung erreicht ist. Bei Öffnen der Tür wird der Schließkeil 21 durch den Mechanismus in die entgegengesetzte Richtung bewegt. Dabei läuft eine auf dem Schließkeil 21 sitzende Nase 19 auf eine Gegenrolle 18 und drückt den Schließkeil 21 und damit das Türblatt 10, 12 von der Zarge 2 weg. Dadurch wird ein sicheres und leichtes Öffnen der Türe erreicht.

**Patentansprüche**

1. Den Durchgang elektromagnetischer Felder verhindernde Tür, bestehend aus einer Zarge (2) und einem Türblatt (10, 12), das entlang seinen Rändern zungenförmige Kontakte (7, 8) aufweist, die mit an der Zarge (2) angebrachten korrespondierenden Kontakten (5, 6) zusammenwirken, wobei wenigstens die Hälfte aller Kontakte (5, 6, 7, 8) mit Kontaktfedern (9) versehen ist,
   **dadurch gekennzeichnet**, daß das Türblatt (10, 12) nur um eine einzige, bezüglich der Zarge (2) feststehende Gelenkachse (20) schwenkbar gelagert ist, wobei wenigstens ein Paar zusammenwirkender Kontakte (6, 8) schräg abgewinkelt ist und der Abstand dieser Kontakte (6, 8) zueinander in keiner der möglichen Stellungen der Tür kleiner ist als in der Schließstellung.

2. Tür nach Anspruch 1, dadurch gekennzeichnet, daß die Richtung wenigstens eines Paares zusammenwirkender Kontakte (6, 8) mit der Verbindungslinie zwischen ihrem bei geschlossener Tür sich ergebenden Berührungspunkt und der Gelenkachse (20) einen rechten Winkel bildet.

3. Tür nach Anspruch 1 oder 2, dadurch gekennzeichnet, daß wenigstens ein Paar zusammenwirkender Kontakte (5, 7) rechtwinkelig zum Türblatt (10, 12) ausgerichtet ist, wobei der an der Zarge (2) angebrachte Kontakt (5) einen kleineren Abstand von der Gelenkachse (20) hat als der an dem Türblatt angebrachte Kontakt (7).

4. Tür nach einem der Ansprüche 1 bis 3, dadurch gekennzeichnet, daß wenigstens ein an der Zarge (2) angebrachter doppelter Kontakt (6) einen etwa U-förmigen Querschnitt mit schräg nach innen abgewinkelten Schenkeln aufweist.

5. Tür nach Anspruch 4, dadurch gekennzeichnet, daß der doppelte Kontakt (6) mit ferromagnetischem Material (14) gefüllt ist.

6. Tür nach Anspruch 4, dadurch gekennzeichnet, daß der doppelte Kontakt (6) mit Absorbermaterial gefüllt ist, das aus Schaumstoff besteht, der mit leitendem, verlustbehafteten Material, insbesondere auf der Basis von Kohlenstoff, getränkt ist.

7. Tür nach einem der Ansprüche 1 bis 6, dadurch gekennzeichnet, daß wenigstens ein an dem Türblatt (10, 12) angebrachter doppelter Kontakt (7) einen etwa U-förmigen Querschnitt mit einem schräg nach außen abgewinkelten Schenkel aufweist.

8. Tür nach einem der Ansprüche 1 bis 7, dadurch gekennzeichnet, daß wenigstens ein an der Zarge (2) angebrachter Kontakt (5) einen L-förmigen Querschnitt mit einem rechtwinkelig abgewinkelten Schenkel aufweist.

9. Tür nach einem der Ansprüche 1 bis 8, dadurch gekennzeichnet, daß wenigstens ein an dem Türblatt (10, 12) angebrachter Kontakt (8) einen etwa L-förmigen Querschnitt mit einem schräg nach außen abgewinkelten Schenkel aufweist.

10. Tür nach einem der Ansprüche 1 bis 9, dadurch gekennzeichnet, daß die Kontakte (5, 6, 7, 8) unter Zwischenlage eines Dichtungsgeflechtes (3), zum Beispiel eines doppelten Gestrickbandes, an der Zarge (2) bzw. an dem Türblatt (10, 12) befestigt sind.

11. Tür nach einem der Ansprüche 1 bis 9, dadurch gekennzeichnet, daß die Kontakte (5, 6, 7, 8) mittels Schutzgas-Schweißung an der Zarge (2) bzw. an dem Türblatt (10, 12) befestigt sind.

12. Tür nach einem der Ansprüche 1 bis 11, dadurch gekennzeichnet, daß die Kontaktfedern (9) auf die Kontakte (5, 6, 7, 8) aufsteckbar sind und einen in eine Nut einrastenden Schnappvershluß aufweisen.

13. Tür nach einem der Ansprüche 1 bis 12, dadurch gekennzeichnet, daß von jedem Paar korrespondierender Kontakte (6/7, 6/8, 5/7) wenigstens einer mit einer Kontaktfeder (9) versehen ist.

14. Tür nach einem der Ansprüche 1 bis 13, dadurch gekennzeichnet, daß die Kontakte (5, 6, 7, 8) in Form von Kontaktreihen, teilweise mit aufgesteckten Kontaktfederreihen, an den Rändern des Türblattes (10, 12) bzw. an der Zarge (2) umlaufend angeordnet sind.

FIG.1

## FIG.2

## FIG.3

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | EP-A-0 095 743 (OY EURAMECANO) <br> * das ganze Dokument * <br> --- | 1 | E06B5/18 <br> H05K9/00 |
| X | FR-A-2 583 099 (ETAT FRANCAIS) <br> * das ganze Dokument * | 1,2,7 | |
| A | <br> --- | 3 | |
| A | DE-A-3 219 263 (SIEMENS) <br> * das ganze Dokument * <br> --- | 1 | |
| A | EP-A-0 265 676 (DORNIER) <br> * das ganze Dokument * <br> --- | 12,14 | |
| A | EP-A-0 233 427 (LHOTELLIER BACHMANN INDUSTRIES) <br> * Abbildung 3B * <br><br> ----- | 1,3 | |

| | |
|---|---|
| | **RECHERCHIERTE SACHGEBIETE (Int. Cl.5 )** |
| | E06B <br> H05K |

Der vorliegende Recherchenbericht wurde für alle Patentansprüche erstellt

| Recherchenort | Abschlußdatum der Recherche | Prüfer |
|---|---|---|
| BERLIN | 24 AUGUST 1992 | KRABEL A. |

EPO FORM 1503 03.82 (P0403)

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
...............................................................................................
& : Mitglied der gleichen Patentfamilie, übereinstimmendes
    Dokument